# EUROPÄISCHE PATENTSCHRIFT

(11) **EP 3 117 488 B1**
(45) Veröffentlichungstag und Bekanntmachung des Hinweises auf die Patenterteilung: **02.01.2019**
(21) Anmeldenummer: 15710470.4
(22) Anmeldetag: 12.03.2015
(51) Int. Cl.: H01R 12/51, H01R 4/28, H01R 4/36, H01R 4/48, H01R 12/72, H01R 13/74

(54) **ANORDNUNG EINER LEITERPLATTENDURCHTAUCHKLEMME AUF EINER LEITERPLATTE**
ARRANGEMENT OF A CIRCUIT BOARD PASSAGE TERMINAL ON A CIRCUIT BOARD
AGENCEMENT D'UNE BORNE À ENFONCER POUR CARTE DE CIRCUITS IMPRIMÉS SUR UNE CARTE DE CIRCUITS IMPRIMÉS

(30) Priorität: 14.03.2014 DE 102014103562
(43) Veröffentlichungstag der Anmeldung: 18.01.2017
(73) Patentinhaber: Phoenix Contact GmbH & Co. KG, 32825 Blomberg (DE)
(72) Erfinder: SCHRADER, Andreas, 33129 Delbrück (DE); WERNER, Ingo, 32760 Detmold (DE)
(74) Vertreter: Janke, Christiane
(86) Internationale Anmeldenummer: PCT/EP2015/055127
(87) Internationale Veröffentlichungsnummer: WO 2015/136020

(56) Entgegenhaltungen:
- EP-A1- 0 871 259
- CA-A1- 2 212 071
- JP-A- H0 864 277
- US-A- 5 445 528
- US-A1- 2006 030 207
- US-A1- 2010 081 341

## Beschreibung

Die Erfindung betrifft eine Anordnung mit einer Leiterplattendurchtauchklemme und einer Leiterplatte gemäß dem Oberbegriff des Anspruchs 1. Ferner betrifft die Erfindung die Verwendung einer Leiterplattendurchtauchklemme zur Anordnung auf einer Leiterplatte gemäß dem Oberbegriff des Anspruchs 6 sowie ein Verfahren zur Anordnung einer Leiterplattendurchtauchklemme auf einer Leiterplatte gemäß dem Oberbegriff des Anspruchs 7.

Aus dem Bereich der Verbindungstechnik ist die Anordnung von Leiterplattendurchtauchklemmen auf Leiterplatten grundsätzlich bekannt. Entsprechende Anordnungen sind beispielsweise aus der US 2006/030207 A1 und der US 2010/081341 A1 bekannt. Derartige Anordnungen weisen in der Regel eine Leiterplatte mit einer Oberseite, einer Unterseite und einer Öffnung zur Aufnahme einer Leiterplattendurchtauchklemme auf. Die Leiterplattendurchtauchklemme umfasst in der Regel ein Gehäuse mit einer Grundleiste zur Aufnahme eines Steckverbinders, Steckkontakte zur elektrischen Verbindung mit der Leiterplatte und eine Auflagevorrichtung zur Lagerung auf und Verbindung mit der Leiterplatte.

Die Leiterplattendurchtauchklemme wird in der Regel von der Oberseite her durch die Öffnung der Leiterplatte geführt und lagert auf der Auflagevorrichtung auf. Die Grundleiste zur Aufnahme des Steckverbinders ist dann auf der Unterseite der Leiterplatte angeordnet.

Bedingt dadurch, dass die bekannten Leiterplattendurchtauchklemmen eine Grundleiste zur Aufnahme eines Steckverbinders aufweisen, ist die Bauhöhe der Leiterplattendurchtauchklemmen entsprechend groß. Zudem ist die Grundleiste zur Aufnahme des Steckverbinders in einer Richtung senkrecht zur Ebene der Leiterplatte angeordnet, was dazu führt, dass Kabel des Steckverbinders ebenfalls in einer Richtung senkrecht zur Ebene der Leiterplatte verlaufen, wodurch die Bauhöhe der Verbindung weiter zunimmt.
Es ist die Aufgabe der Erfindung, eine Anordnung einer Leiterplattendurchtauchklemme auf einer Leiterplatte anzugeben, wobei die Leiterplattendurchtauchklemme einfach auf der Leiterplatte angeordnet werden kann, eine geringe Bauhöhe aufweist und eine einfache Kontaktierung von elektrischen Leitern ermöglicht.
Diese Aufgabe wird durch die Gegenstände der unabhängigen Ansprüche gelöst. Bevorzugte Weiterbildungen sind in den Unteransprüchen angegeben.

Die erfindungsgemäße Anordnung zeichnet sich dadurch aus, dass das Kontaktelement als Lötstift ausgebildet ist, wobei der Lötstift auf der Außenwand des Gehäuses in einer Richtung senkrecht zur Ebene der Außenwand angeordnet ist, in der Ausnehmung der Leiterplatte (30) ein Schlitz (351) ausgebildet ist und die Leiterplattendurchtauchklemme (20) derart in der Ausnehmung (35) der Leiterplatte (30) angeordnet ist, dass der Lötstift in den Schlitz (351) eingreift und mit der Lötseite (31) der Leiterplatte (30) verlötet ist.
Es ist somit ein wesentlicher Aspekt der Erfindung, dass die Leiterplattendurchtauchklemme ein Gehäuse mit einer Leiteraufnahmeöffnung zur Aufnahme eines elektrischen Leiters und einer Bedienöffnung zum Fixieren oder Lösen eines in die Leiteraufnahmeöffnung eingeführten elektrischen Leiters aufweist. Auf diese Weise können einzelne elektrische Leiter in die Leiteraufnahmeöffnung der Leiterplattendurchtauchklemme eingeführt und elektrische kontaktiert werden, wodurch die Bauteilhöhe der Leiterplattendurchtauchklemme reduziert werden kann.

Eine nicht beanspruchte Weiterbildung liegt darin, dass die Leiterplattendurchtauchklemme eine Printklemme ist. Auf diese Weise kann der elektrische Leiter einfach in die Leiteraufnahmeöffnung eingeführt und elektrisch kontaktiert werden.
Grundsätzlich kann die Ausnehmung der Leiterplatte in der Ebene der Leiterplatte angeordnet sein. In diesem Fall wird die Leiterplattendurchtauchklemme in einer Richtung senkrecht zur Ebene der Leiterplatte in die Ausnehmung eingesteckt und auf der Leiterplatte angeordnet. Eine bevorzugte Weiterbildung der Erfindung sieht jedoch vor, dass die Leiterplatte einen Randbereich aufweist und die Ausnehmung im Randbereich der Leiterplatte angeordnet ist. Auf diese Weise kann die Leiterplattendurchtauchklemme in einer Richtung senkrecht zur Ebene der Leiterplatte in die Ausnehmung eingesteckt oder in einer Richtung parallel zur Ebene der Leiterplatte in die Ausnehmung der Leiterplatte aufgeschoben werden.
Eine Außenwand des Gehäuses der Leiterplattendurchtauchklemme ist in einer Ebene parallel zur Ebene der Auflagefläche des Flanschbauteils angeordnet. Die Leiterplattendurchtauchklemme ist derart auf der Leiterplatte angeordnet, dass die Auflagefläche des Flanschbauteils auf der Lötseite der Leiterplatte aufliegt und zumindest ein Teilbereich der Außenwand des Gehäuses auf der Bauteilseite der Leiterplatte anliegt. Auf diese Weise wird eine Anordnung der Leiterplattendurchtauchklemme auf der Leiterplatte angegeben, bei der die Leiterplattendurchtauchklemme in einer Richtung senkrecht zur Ebene der Leiterplatte formschlüssig auf der Leiterplatte fixiert wird. Mechanische Kräfte, die in einer Richtung senkrecht zur Ebene der Leiterplatte auf die Leiterplattendurchtauchklemme wirken werden auf diese Weise entweder über das Flanschbauteil oder über den an der Bauteilseite des anliegenden Teilbereich der Außenwand auf die Leiterplatte übertragen.

Eine weitere nicht beanspruchte Weiterbildung sieht vor, dass das Flanschbauteil derart am Gehäuse der Leiterplattendurchtauchklemme angeordnet ist, dass die Außenwand des Gehäuses und die Außenfläche des Flanschbauteils eine Ebene bilden. Auf diese Weise wird die Bauteilhöhe der Leiterplattendurchtauchklemme auf der Lötseite der Leiterplatte durch die Höhe des Flanschbauteils bestimmt. In Abhängigkeit der Höhe des Flanschbauteils kann damit der Schattenwurf der Leiterplattendurchtauchklemme auf der Lötseite reduziert werden, was insbesondere bei der Anordnung der Leiterplattendurchtauchklemme bei LED-Anwendungen von Vorteil sein kann.

Gemäß einer weiteren nicht beanspruchten Weiterbildung ist vorgesehen, dass das Flanschbauteil ein aus einem lötfähigen Material bestehender Anker ist, der in das Gehäuse der Leiterplattendurchtauchklemme eingepresst ist. In diesem Zusammenhang sieht eine weitere Weiterbildung vor, dass der Anker auf der Lötseite der Leiterplatte mit dieser verlötet ist. Auf diese Weise wird die Leiterplattendurchtauchklemme stoffschlüssig mit der Leiterplatte verbunden. Über die stoffschlüssige Verbindung können die auf die Anordnung auftretenden mechanischen Kräfte, wie beispielsweise die mechanischen Kräfte, die beim Einstecken und Kontaktieren des elektrischen Leiters in die Leiterplattendurchtauchklemme auf die Anordnung wirken, aufgenommen werden.
Weiterhin weist der aus einem lötfähigen Material bestehende Anker vorzugsweise eine -Flanschhöhe zwischen 0,5 mm und 3 mm auf. Bei einer derartigen Anordnung des Ankers am Gehäuse der Leiterplattendurchtauchklemme, dass die Außenfläche des Ankers eine Ebene mit der Außenwand des Gehäuses bildet, kann die Bauteilhöhe der Leiterplattendurchtauchklemme auf der Lötseite der Leiterplatte reduziert und somit der Schattenwurf verringert werden.
Alternativ zu dem Anker aus einen lötfähigen Material sieht eine weitere nicht beanspruchte Weiterbildung vor, dass das Flanschbauteil einstückig mit dem Gehäuse der Leiterplattendurchtauchklemme ausgebildet ist. Auf diese Weise kann das Gehäuse der Leiterplattendurchtauchklemme mit geringem Aufwand hergestellt werden.

Gemäß einer weiteren nicht beanspruchten Weiterbildung ist vorgesehen, dass das Kontaktelement als Lötfahne ausgebildet ist, wobei die Lötfahne vorzugsweise auf der Außenwand des Gehäuses angeordnet ist und die Lötfahne zur elektrischen Kontaktierung mit der Lötseite der Leiterplatte verlötet ist. Auf diese Weise kann die Leiterplattendurchtauchklemme vorzugsweise als SMDlötfähige Leiterplattendurchtauchklemme ausgebildet und auf der Leiterplatte angeordnet sein.

Das Kontaktelement ist als Lötstift ausgebildet, wobei der Lötstift auf der Außenwand des Gehäuses in einer Richtung senkrecht zur Ebene der Außenwand angeordnet ist. In der Ausnehmung der Leiterplatte ist ein Schlitz ausgebildet und die Leiterplattendurchtauchklemme ist derart in der Ausnehmung der Leiterplatte angeordnet, dass der Lötstift in den Schlitz eingreift und mit der Lötseite der Leiterplatte verlötet ist. Auf diese Weise wird eine Leiterplattendurchtauchklemme angegeben, die in einer Richtung parallel zur Ebene der Leiterplatte in die Ausnehmung der Leiterplatte einschiebbar ist und der Lötstift durch die Leiterplatte geführt wird.

Eine weitere vorteilhafte Weiterbildung der Erfindung liegt darin, dass die Leiteraufnahmeöffnung derart angeordnet ist, dass ein elektrischer Leiter auf der Bauteilseite der Leiterplatte in die Leiteraufnahmeöffnung einführbar ist. Somit kann die Bauteilhöhe der Leiterplattendurchtauchklemme auf der Lötseite reduziert werden.

Weiterhin sieht eine besonders bevorzugte Weiterbildung der Erfindung vor, dass die Leiteraufnahmeöffnung derart angeordnet ist, dass ein elektrischer Leiter in einer Richtung parallel zur Ebene der Leiterplatte in die Leiteraufnahmeöffnung einführbar ist. Auf diese Weise wirken die mechanischen Kräfte, die beim Einführen eines elektrischen Leiters in die Leiteraufnahmeöffnung auf die Anordnung wirken, in einer Richtung parallel zur Ebene der Leiterplatte.

Zudem wird auf diese Weise eine Anordnung angegeben, die eine geringe Bauhöhe der Leiterplattendurchtauchklemme ermöglicht, da der mit der Leiterplattendurchtauchklemme zu kontaktierende Leiter in einer Richtung parallel zur Ebene der Leiterplatte geführt und auch in einer Richtung parallel zur Ebene der Leiterplatte in die Leiteraufnahmeöffnung eingeführt werden kann. Außerdem werden Anwendern auf diese Weise weitere Freiheiten bei der Auslegung der Kontur eines die Leiterplatte aufnehmenden Gehäuses ermöglicht.
Die Bedienöffnung zum Fixieren oder Lösen eines in die Leiteraufnahmeöffnung eingeführten elektrischen Leiters kann an unterschiedlichen Stellen am Gehäuse der Leiterplattendurchtauchklemme angeordnet sein. Eine bevorzugte Weiterbildung der Erfindung sieht jedoch vor, dass die Bedienöffnung in einer Richtung parallel zur Leiteraufnahmeöffnung oder in einer Richtung senkrecht zur Leiteraufnahmeöffnung angeordnet ist. Bei einer Anordnung der Bedienöffnung in einer Richtung parallel zur Leiteraufnahmeöffnung wirken die mechanischen Kräfte, die beim Fixieren oder Lösen eines elektrischen Leiters in bzw. aus der Leiteraufnahmeöffnung auf die Anordnung wirken, in einer Richtung parallel zur Ebene der Leiterplatte.

Bei einer Anordnung der Bedienöffnung in einer Richtung senkrecht zur Leiteraufnahmeöffnung liegt eine nicht beanspruchte Weiterbildung darin, dass die Bedienöffnung in der Außenwand des Gehäuses der Leiterplattendurchtauchklemme angeordnet ist. Auf diese Weise wirken die mechanischen Kräfte, die beim Fixieren oder Lösen eines elektrischen Leiters in bzw. aus der Leiteraufnahmeöffnung auf die Anordnung wirken, in einer Richtung senkrecht zur Ebene der Leiterplatte, wobei Druckkräfte über die Flanschverbindung auf die Leiterplatte übertragen werden.

Eine weitere nicht beanspruchte Weiterbildung liegt darin, dass die Leiterplattendurchtauchklemme eine Mehrzahl von Leiteraufnahmeöffnungen, eine Mehrzahl von Bedienöffnungen und eine Mehrzahl von Kontaktelementen aufweist.

Weiterhin ist eine nicht beanspruchte Weiterbildung darin zu sehen, dass die Leiterplattendurchtauchklemme eine Mehrzahl von Flanschbauteilen aufweist. Auf diese Weise kann die Verbindung der Leiterplattendurchtauchklemme zur Leiterplatte erhöht werden.

Die Erfindung betrifft zudem die Verwendung einer Leiterplattendurchtauchklemme zur Anordnung auf einer Leiterplatte, welche sich dadurch auszeichnet, dass das Kontaktelement als Lötstift ausgebildet ist, wobei der Lötstift auf der Außenwand des Gehäuses in einer Richtung senkrecht zur Ebene der Außenwand angeordnet ist, in der Ausnehmung der Leiterplatte ein Schlitz ausgebildet ist und die Leiterplattendurchtauchklemme derart in der Ausnehmung der Leiterplatte angeordnet ist, dass der Lötstift in den Schlitz eingreift und mit der Lötseite der Leiterplatte verlötet ist.
Erfindungsgemäß ist zudem ein Verfahren zur Anordnung einer Leiterplattendurchtauchklemme auf einer Leiterplatte vorgesehen, welches sich dadurch auszeichnet, dass das Kontaktelement als Lötstift ausgebildet ist, wobei der Lötstift auf der Außenwand des Gehäuses in einer Richtung senkrecht zur Ebene der Außenwand angeordnet wird, in der Ausnehmung der Leiterplatte ein Schlitz ausgebildet wird und die Leiterplattendurchtauchklemme derart in der Ausnehmung der Leiterplatte angeordnet wird, dass der Lötstift in den Schlitz eingreift und mit der Lötseite der Leiterplatte verlötet wird.

Die Beschreibung der Anordnung einer Leiterplattendurchtauchklemme auf einer Leiterplatte und insbesondere die Weiterbildungen der Erfindung finden ebenfalls für die Verwendung einer Leiterplattendurchtauchklemme zur Anordnung auf einer Leiterplatte und für das Verfahren zur Anordnung einer Leiterplattendurchtauchklemme auf einer Leiterplatte Anwendung.

Nachfolgend wird die Erfindung anhand eines bevorzugten Ausführungsbeispiels unter Bezugnahme auf die Zeichnung näher erläutert. In der Zeichnung zeigen:
- Fig. 1: eine dreidimensionale Ansicht einer Anordnung zweier Leiterplattendurchtauchklemmen auf einer Leiterplatte gemäß einem bevorzugten Ausführungsbeispiel der Erfindung,
- Fig. 2: eine weitere dreidimensionale Ansicht der Anordnung zweier Leiterplattendurchtauchklemmen auf der Leiterplatte gemäß dem bevorzugten Ausführungsbeispiel der Erfindung und
- Fig. 3: eine Seitenansicht der Anordnung zweier Leiterplattendurchtauchklemmen auf der Leiterplatte gemäß dem bevorzugten Ausführungsbeispiel der Erfindung.

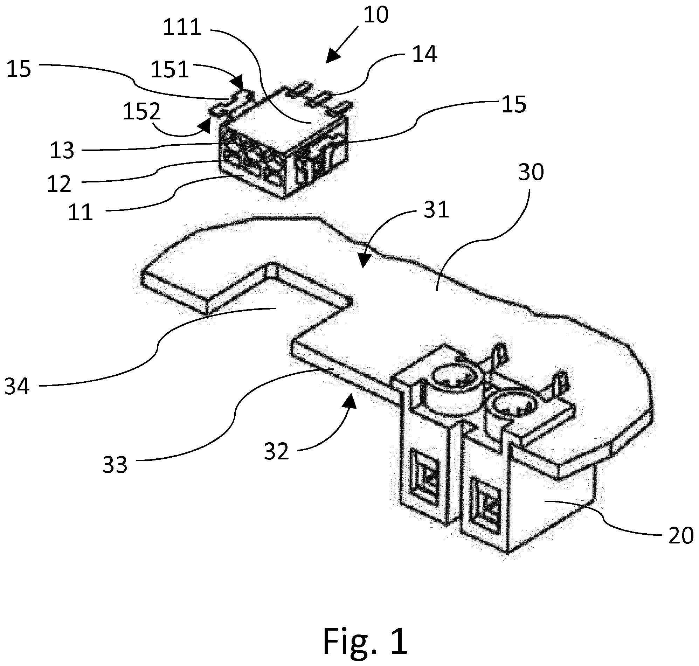

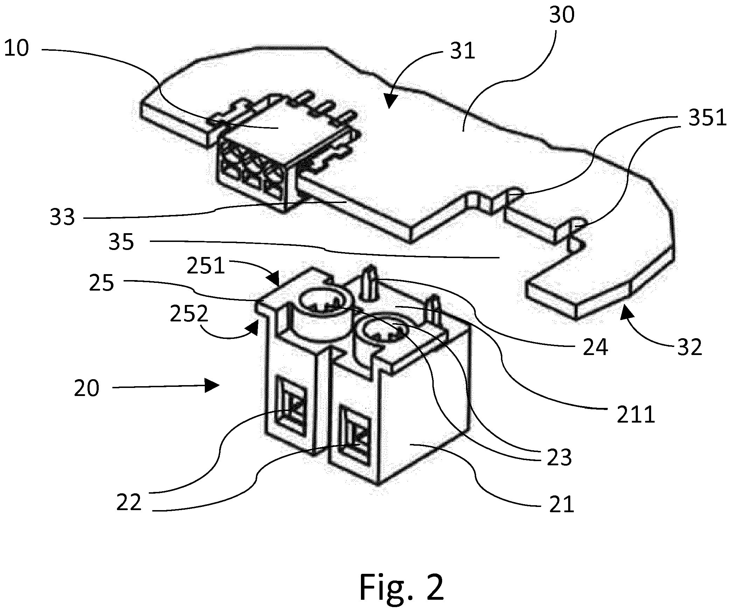

In Figur 1 und 2 ist die Anordnung einer ersten Leiterplattendurchtauchklemme 10 und einer zweiten Leiterplattendurchtauchklemme 20 auf einer Leiterplatte 30 gezeigt. Die Anordnung der ersten Leiterplattendurchtauchklemme 10 auf der Leiterplatte 30 wird unter Bezugnahme auf Figur 1 beschrieben. Auf die Anordnung der zweiten Leiterplattendurchtauchklemme 20 auf der Leiterplatte 30 wird unter Bezugnahme Figur 2 näher eingegangen.

Wie aus Figur 1 ersichtlich, umfasst die Leiterplatte 30 eine Lötseite 31 und eine Bauteilseite 32. Zudem weist die Leiterplatte 30 einen Randbereich 33 und eine im Randbereich 33 angeordnete erste Ausnehmung 34 zur Aufnahme der ersten Leiterplattendurchtauchklemme 10 auf.

Die erste Leiterplattendurchtauchklemme 10 weist ein Gehäuse 11 mit drei nebeneinander angeordneten Leiteraufnahmeöffnung 12 zur jeweiligen Aufnahme eines elektrischen Leiters auf. Parallel zu den Leiteraufnahmeöffnungen 12 sind drei nebeneinander angeordnete Bedienöffnung 13 zum Fixieren oder Lösen des jeweiligen in die entsprechende Leiteraufnahmeöffnung 12 eingeführten elektrischen Leiters angeordnet. Entsprechend der Anzahl der Leiteraufnahmeöffnungen 12 weist die erste Leiterplattendurchtauchklemme 10 drei Kontaktelemente 14 zur Verlötung und elektrischen Kontaktierung der ersten Leiterplattendurchtauchklemme 10 mit der Lötseite 31 der Leiterplatte 30 auf.

Weiterhin umfasst die erste Leiterplattendurchtauchklemme 10 zwei Flanschbauteile 15 mit einer Außenfläche 151 und einer Auflagefläche 152, wobei die Flanschbauteile 15 jeweils als Anker aus einem lötfähigen Material ausgebildet sind und in das Gehäuse 11 der ersten Leiterplattendurchtauchklemme 10 eingepresst sind.

Zur Anordnung der erste Leiterplattendurchtauchklemme 10 auf die Leiterplatte 30 kann die erste Leiterplattendurchtauchklemme 10 einerseits in einer Richtung senkrecht zur Ebene der Leiterplatte 30 in die erste Ausnehmung 34 der Leiterplatte 30 eingesteckt werden, so dass die Flanschbauteile 15 dann mit der Auflagefläche 152 auf der Lötseite 31 der Leiterplatte 30 aufliegen. Alternativ dazu kann die erste Leiterplattendurchtauchklemme 10 aber auch in einer Richtung parallel zur Ebene der Leiterplatte 30 in die erste Ausnehmung 34 der Leiterplatte 30 eingeschoben werden, so dass die Flanschbauteile 15 mit der Auflagefläche 152 auf der Lötseite 31 der Leiterplatte 30 aufliegen.

Bedingt dadurch, dass die Flanschbauteile 15 als Anker aus einem lötfähigen Material ausgebildet sind, kann die erste Leiterplattendurchtauchklemme über eine Lötverbindung stoffschlüssig mit der Lötseite 31 der Leiterplatte verbunden werden.

Weiterhin ist ersichtlich, dass das Gehäuse 11 der ersten Leiterplattenlötverbindung 10 eine Außenwand 111 aufweist und die Außenfläche 151 der Flanschbauteile 15 mit der Außenwand 111 eine Ebene bilden. Auf diese wird die Bauteilhöhe der ersten Leiterplattendurchtauchklemme 10 auf der Lötseite 31 der Leiterplatte 30 durch die Höhe des Flanschbauteils 15 bestimmt. In Abhängigkeit der Höhe des Flanschbauteils 15 kann auf diese Weise der Schattenwurf der ersten Leiterplattendurchtauchklemme 10 auf der Lötseite 31 reduziert werden, was insbesondere bei der Verwendung der ersten Leiterplattendurchtauchklemme 10 für LED-Anwendungen von Vorteil sein kann.

Aus Figur 1 ist zudem ersichtlich, dass die Leiteraufnahmeöffnungen 12 derart angeordnet sind, dass ein elektrischer Leiter in einer Richtung parallel zur Ebene der Leiterplatte 30 in die Leiteraufnahmeöffnung 12 einführbar ist. Auf diese Weise wirken die mechanischen Kräfte, die beim Einführen eines elektrischen Leiters in die Leiteraufnahmeöffnung 12 auf die Anordnung wirken, in einer Richtung parallel zur Ebene der Leiterplatte 30.

Die mechanischen Kräfte, die beim Fixieren oder Lösen eines elektrischen Leiters in bzw. aus der Leiteraufnahmeöffnung 12 auf die Anordnung wirken, wirken ebenso in einer Richtung parallel zur Ebene der Leiterplatte 30, da die Bedienöffnungen 13 in einer Richtung parallel zu der Richtung der Leiteraufnahmeöffnungen 12 angeordnet sind.

In Figur 2 ist die aus Figur 1 bekannte Leiterplatte 30 mit einer zweiten Ausnehmung 35 zur Aufnahme der zweiten Leiterplattendurchtauchklemme 20 gezeigt. Die zweite Leiterplattendurchtauchklemme 20 weist ein Gehäuse 21 mit zwei nebeneinander angeordneten Leiteraufnahmeöffnungen 22 zur jeweiligen Aufnahme eines elektrischen Leiters und zwei Bedienöffnungen 23 zum Fixieren oder Lösen des jeweiligen in die entsprechende Leiteraufnahmeöffnung 22 eingeführten elektrischen Leiters auf, wobei die Bedienöffnungen 23 in einer Richtung senkrecht zur Richtung der Leiteraufnahmeöffnungen 22 angeordnet sind. Weiterhin ist ersichtlich, dass die Bedienöffnungen 23 in der Außenwand 211 des Gehäuses 21 angeordnet sind.

Die zweite Leiterplattendurchtauchklemme 20 weist zudem auf der Außenwand 211 zwei Kontaktelemente 24 auf, die jeweils als Lötstift ausgebildet sind. Weiterhin sind am Gehäuse 21 der zweiten Leiterplattendurchtauchklemme 20 zwei Flanschbauteil 25 angeordnet, wobei die Flanschbauteil 25 jeweils eine Außenfläche 251 und eine Auflagefläche 252 aufweisen. Die Flanschbauteil 25 sind einstückig mit dem Gehäuse 21 der zweiten Leiterplattendurchtauchklemme 20 ausgebildet.

Zur Anordnung der zweiten Leiterplattendurchtauchklemme 20 auf der Leiterplatte 30 wird die zweite Leiterplattendurchtauchklemme 20 in einer Richtung parallel zur Ebene der Leiterplatte 30 in die zweite Ausnehmung 35 eingeschoben, wobei die Auflagefläche 252 der jeweiligen Flanschbauteil 25 auf der Lötseite 31 der Leiterplatte 30 aufliegt und der Bereich der Außenwand 211, in welchem die Kontaktelemente 24 angeordnet sind, an der Bauteilseite 32 der Leiterplatte anliegt. Zudem greift jedes Kontaktelemente 24 jeweils in einen Schlitz 351 der Leiterplatte 30 ein. Auf diese Weise wird die zweite Leiterplattendurchtauchklemme 20 in einer Richtung senkrecht zur Ebene der Leiterplatte 30 formschlüssig mit der Leiterplatte 30 fixiert. Durch das Verlöten der Kontaktelemente 24 mit der Lötseite 31 der Leiterplatte 30 wird die zweite Leiterplattendurchtauchklemme 20 mit der Leiterplatte 30 elektrisch kontaktiert.

Weiterhin ist ersichtlich, dass die Leiteraufnahmeöffnungen 22 derart angeordnet sind, dass ein elektrischer Leiter in einer Richtung parallel zur Ebene der Leiterplatte 30 in die Leiteraufnahmeöffnung 22 einführbar ist. Auf diese Weise wirken die mechanischen Kräfte, die beim Einführen eines elektrischen Leiters in die Leiteraufnahmeöffnung 22 auf die Anordnung wirken, in einer Richtung parallel zur Ebene der Leiterplatte 30.

Bedingt dadurch, dass die Bedienöffnungen 23 in einer Richtung senkrecht zur Richtung der Leiteraufnahmeöffnungen 22 angeordnet sind, wirken die mechanischen Kräfte, die beim Fixieren oder Lösen eines elektrischen Leiters in bzw. aus der Leiteraufnahmeöffnung 22 auf die Anordnung wirken, in einer Richtung senkrecht zur Ebene der Leiterplatte 30, wobei Druckkräfte über die Flanschverbindung 15 auf die Leiterplatte 30 übertragen werden.

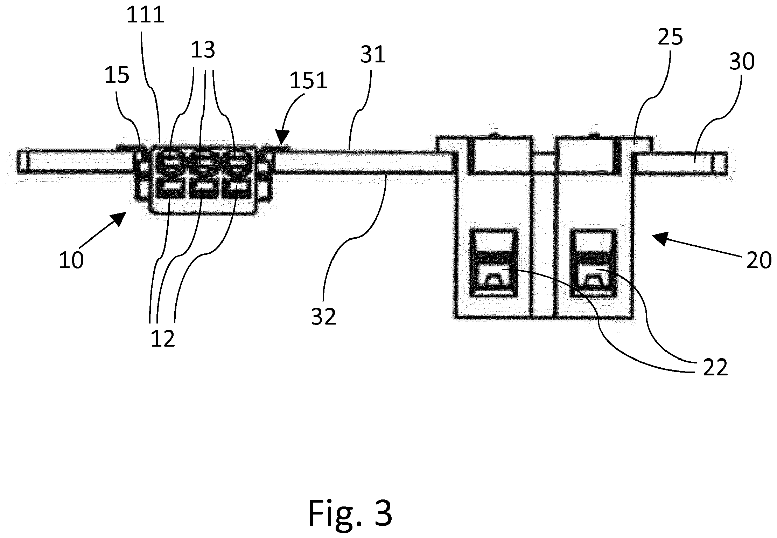

In Figur 3 ist die Anordnung der ersten Leiterplattendurchtauchklemme 10 auf der Leiterplatte 30 und die Anordnung der zweiten Leiterplattendurchtauchklemme 20 auf der Leiterplatte 30 dargestellt. Weiterhin ist ersichtlich, dass die Leiteraufnahmeöffnungen 12, 22 derart angeordnet sind, dass ein elektrischer Leiter auf der Bauteilseite 32 der Leiterplatte 30 in die entsprechende Leiteraufnahmeöffnung 12, 22 einführbar ist. Somit kann die Bauteilhöhe der ersten Leiterplattendurchtauchklemme 10 bzw. der zweiten Leiterplattendurchtauchklemme 20 auf der Lötseite 31 reduziert werden.

### Bezugszeichen

- 10: Erste Leiterplattendurchtauchklemme
- 11: Gehäuse
- 111: Außenwand
- 12: Leiteraufnahmeöffnung
- 13: Bedienöffnung
- 14: Kontaktelemente
- 15: Flanschbauteil
- 151: Außenfläche
- 152: Auflagefläche

- 20: Zweite Leiterplattendurchtauchklemme
- 21: Gehäuse
- 211: Außenwand
- 22: Leiteraufnahmeöffnung
- 23: Bedienöffnung
- 24: Kontaktelement
- 25: Flanschbauteil
- 251: Außenfläche
- 252: Auflagefläche

- 30: Leiterplatte
- 31: Lötseite
- 32: Bauteilseite
- 33: Randbereich
- 34: Erste Ausnehmung
- 35: Zweite Ausnehmung
- 351: Schlitz

## Patentansprüche

1. Anordnung, mit einer Leiterplattendurchtauchklemme (10, 20) und einer Leiterplatte (30),
wobei die Leiterplatte (30) eine Lötseite (31) und eine Bauteilseite (32) aufweist
und in der Leiterplatte (30) eine Ausnehmung (34, 35) zur Aufnahme der Leiterplattendurchtauchklemme (10, 20) angeordnet ist,
wobei die Leiterplattendurchtauchklemme (10, 20) ein Gehäuse (11, 21) mit einer Leiteraufnahmeöffnung (12, 22) zur Aufnahme eines elektrischen Leiters und einer Bedienöffnung (13, 23) zum Fixieren oder Lösen eines in die Leiteraufnahmeöffnung (12,22) eingeführten elektrischen Leiters aufweist,
ein Kontaktelement (14) zur Verlötung und elektrischen Kontaktierung der Leiterplattendurchtauchklemme (10, 20) mit der Lötseite (31) der Leiterplatte (30) umfasst und
ein Flanschbauteil (15, 25) mit einer Außenfläche (151, 251) und einer Auflagefläche (152, 252) aufweist,
und bei der in der Ausnehmung (34, 35) der Leiterplatte (30) angeordneten Leiterplattendurchtauchklemme (10, 20) das Flanschbauteil (15, 25) mit der Auflagefläche (152, 252) auf der Lötseite (31) der Leiterplatte (30) aufliegt,
wobei eine Außenwand (111, 211) des Gehäuses (11, 21) der Leiterplattendurchtauchklemme (10, 20) in einer Ebene parallel zur Ebene der Auflagefläche (152, 252) des Flanschbauteils (15, 25) angeordnet ist und
wobei die Leiterplattendurchtauchklemme (20) derart auf der Leiterplatte (30) angeordnet ist, dass die Auflagefläche (252) des Flanschbauteils (25) auf der Lötseite (31) der Leiterplatte (30) aufliegt und zumindest ein Teilbereich der Außenwand (211) des Gehäuses (21) auf der Bauteilseite (32) der Leiterplatte (30) anliegt,
**dadurch gekennzeichnet, dass** das Kontaktelement (14) als Lötstift ausgebildet ist, wobei der Lötstift auf der Außenwand (211) des Gehäuses (20) in einer Richtung senkrecht zur Ebene der Außenwand (211) angeordnet ist, in der Ausnehmung (35) der Leiterplatte (30) ein Schlitz (351) ausgebildet ist und die Leiterplattendurchtauchklemme (20) derart in der Ausnehmung (35) der Leiterplatte (30) angeordnet ist, dass der Lötstift in den Schlitz (351) eingreift und mit der Lötseite (31) der Leiterplatte (30) verlötet ist.

2. Anordnung nach Anspruch 1, **dadurch gekennzeichnet, dass** die Leiterplatte (30) einen Randbereich (33) aufweist und die Ausnehmung (34, 35) im Randbereich (33) der Leiterplatte (30) angeordnet ist.

3. Anordnung nach Anspruch 1 oder 2, **dadurch gekennzeichnet, dass** die Leiteraufnahmeöffnung (12, 22) derart angeordnet ist, dass ein elektrischer Leiter auf der Bauteilseite (32) der Leiterplatte (30) in die Leiteraufnahmeöffnung (12, 22) einführbar ist.

4. Anordnung nach einem der Ansprüche 1 bis 3, **dadurch gekennzeichnet, dass** die Leiteraufnahmeöffnung (12, 22) derart angeordnet ist, dass ein elektrischer Leiter in einer Richtung parallel zur Ebene der Leiterplatte (30) in die Leiteraufnahmeöffnung (12, 22) einführbar ist.

5. Anordnung nach einem der Ansprüche 1 bis 4, **dadurch gekennzeichnet, dass** die Bedienöffnung (13, 23) in einer Richtung parallel zur Leiteraufnahmeöffnung (12, 22) oder in einer Richtung senkrecht zur Leiteraufnahmeöffnung (12, 22) angeordnet ist.

6. Verwendung einer Leiterplattendurchtauchklemme (10, 20) zur Anordnung auf einer Leiterplatte (30),
wobei die Leiterplatte (30) eine Lötseite (31) und eine Bauteilseite (32) aufweist
und in der Leiterplatte (30) eine Ausnehmung (34, 35) zur Aufnahme der Leiterplattendurchtauchklemme (10, 20) angeordnet ist,
wobei die Leiterplattendurchtauchklemme (10, 20) ein Gehäuse (11, 21) mit einer Leiteraufnahmeöffnung (12, 22) zur Aufnahme eines elektrischen Leiters und einer Bedienöffnung (13, 23) zum Fixieren oder Lösen eines in die Leiteraufnahmeöffnung (12, 22) eingeführten elektrischen Leiters aufweist,
ein Kontaktelement (14, 24) zur Verlötung und elektrischen Kontaktierung der Leiterplattendurchtauchklemme (10, 20) mit der Lötseite (31) der Leiterplatte (30) umfasst und
ein Flanschbauteil (15, 25) mit einer Außenfläche (151, 251) und einer Auflagefläche (152, 252) aufweist, und bei der in der Ausnehmung (34, 35) der Leiterplatte (30) angeordneten Leiterplattendurchtauchklemme (10, 20) das Flanschbauteil (15, 25) mit der Auflagefläche (152, 252) auf der Lötseite (31) der Leiterplatte (30) fixiert ist,
wobei eine Außenwand (111, 211) des Gehäuses (11, 21) der Leiterplattendurchtauchklemme (10, 20) in einer Ebene parallel zur Ebene der Auflagefläche (152, 252) des Flanschbauteils (15, 25) angeordnet ist und
wobei die Leiterplattendurchtauchklemme (20) derart auf der Leiterplatte (30) angeordnet ist, dass die Auflagefläche (252) des Flanschbauteils (25) auf der Lötseite (31) der Leiterplatte (30) aufliegt und zumindest ein Teilbereich der Außenwand (211) des Gehäuses (21) auf der Bauteilseite (32) der Leiterplatte (30) anliegt,
**dadurch gekennzeichnet, dass** das Kontaktelement (14) als Lötstift ausgebildet ist, wobei der Lötstift auf der Außenwand (211) des Gehäuses (20) in einer Richtung senkrecht zur Ebene der Außenwand (211) angeordnet ist, in der Ausnehmung (35) der Leiterplatte (30) ein Schlitz (351) ausgebildet ist und die Leiterplattendurchtauchklemme (20) derart in der Ausnehmung (35) der Leiterplatte (30) angeordnet ist, dass der Lötstift in den Schlitz (351) eingreift und mit der Lötseite (31) der Leiterplatte (30) verlötet ist.

7. Verfahren zur Anordnung einer Leiterplattendurchtauchklemme (10, 20) auf einer Leiterplatte (30),
wobei die Leiterplatte (30) eine Lötseite (31) und eine Bauteilseite (32) aufweist
und in der Leiterplatte (30) eine Ausnehmung (34, 35) zur Aufnahme der Leiterplattendurchtauchklemme (10, 20) angeordnet ist,
wobei die Leiterplattendurchtauchklemme (10, 20) ein Gehäuse (11, 21) mit einer Leiteraufnahmeöffnung (12, 22) zur Aufnahme eines elektrischen Leiters und einer Bedienöffnung (13, 23) zum Fixieren oder Lösen eines in die Leiteraufnahmeöffnung (12, 22) eingeführten elektrischen Leiters aufweist,
ein Kontaktelement (14, 24) zur Verlötung und elektrischen Kontaktierung der Leiterplattendurchtauchklemme (10, 20) mit der Lötseite (31) der Leiterplatte (30) umfasst und
ein Flanschbauteil (15, 25) mit einer Außenfläche (151, 251) und einer Auflagefläche (152, 252) aufweist
und wobei die Leiterplattendurchtauchklemme (10, 20) in einer Richtung senkrecht zur Ebene der Leiterplatte (30) in die Ausnehmung (34, 35) der Leiterplatte (30) eingesteckt wird, wobei das Flanschbauteil (15, 25) mit der Auflagefläche (152, 252) auf der Lötseite (31) der Leiterplatte (30) aufliegt, oder die Leiterplattendurchtauchklemme (10, 20) in einer Richtung parallel zur Ebene der Leiterplatte (30) in die Ausnehmung (34, 35) der Leiterplatte (30) eingeschoben wird, wobei das Flanschbauteil (15, 25) mit der Auflagefläche (152, 252) auf der Lötseite (31) der Leiterplatte (30) aufliegt,
wobei eine Außenwand (111, 211) des Gehäuses (11, 21) der Leiterplattendurchtauchklemme (10, 20) in einer Ebene parallel zur Ebene der Auflagefläche (152, 252) des Flanschbauteils (15, 25) angeordnet wird und
wobei die Leiterplattendurchtauchklemme (20) derart auf der Leiterplatte (30) angeordnet wird, dass die Auflagefläche (252) des Flanschbauteils (25) auf der Lötseite (31) der Leiterplatte (30) aufliegt und zumindest ein Teilbereich der Außenwand (211) des Gehäuses (21) auf der Bauteilseite (32) der Leiterplatte (30) anliegt, **dadurch gekennzeichnet, dass** das Kontaktelement (14) als Lötstift ausgebildet ist, wobei der Lötstift auf der Außenwand (211) des Gehäuses (20) in einer Richtung senkrecht zur Ebene der Außenwand (211) angeordnet wird, in der Ausnehmung (35) der Leiterplatte (30) ein Schlitz (351) ausgebildet wird und die Leiterplattendurchtauchklemme (20) derart in der Ausnehmung (35) der Leiterplatte (30) angeordnet wird, dass der Lötstift in den Schlitz (351) eingreift und mit der Lötseite (31) der Leiterplatte (30) verlötet wird.

## Claims

1. Arrangement comprising a printed circuit board passage terminal (10, 20) and a printed circuit board (30),
wherein the printed circuit board (30) has a solder side (31) and a component side (32)
and a recess (34, 35) for receiving the printed circuit board passage terminal (10, 20) is arranged in the printed circuit board (30),
wherein the printed circuit board passage terminal (10, 20) has a housing (11, 21) with a conductor receiving opening (12, 22) for receiving an electrical conductor and with an operator control opening (13, 23) for fixing or releasing an electrical conductor which is inserted into the conductor receiving opening (12, 22), comprises a contact element (14) for soldering and electrically contact-connecting the printed circuit board passage terminal (10, 20) to the solder side (31) of the printed circuit board (30) and
has a flange component (15, 25) with an outer face (151, 251) and a support face (152, 252),
and, with the printed circuit board passage terminal (10, 20) arranged in the recess (34, 35) of the printed circuit board (30), the flange component (15, 25), by way of the support face (152, 252), is supported on the solder side (31) of the printed circuit board (30),
wherein an outer wall (111, 211) of the housing (11, 21) of the printed circuit board passage terminal (10, 20) is arranged in a plane parallel to the plane of the support face (152, 252) of the flange component (15, 25), and
wherein the printed circuit board passage terminal (20) is arranged on the printed circuit board (30) in such a way that the support face (252) of the flange component (25) is supported on the solder side (31) of the printed circuit board (30) and at least a subregion of the outer wall (211) of the housing (21) rests on the component side (32) of the printed circuit board (30), **characterized in that** the contact element (14) is in the form of a solder pin, wherein the solder pin is arranged on the outer wall (211) of the housing (20) in a direction perpendicular to the plane of the outer wall (211), a slot (351) is formed in the recess (35) of the printed circuit board (30), and the printed circuit board passage terminal (20) is arranged in the recess (35) of the printed circuit board (30) in such a way that the solder pin engages into the slot (351) and is soldered to the solder side (31) of the printed circuit board (30).

2. Arrangement according to Claim 1, **characterized in that** the printed circuit board (30) has an edge region (33) and the recess (34, 35) is arranged in the edge region (33) of the printed circuit board (30).

3. Arrangement according to Claim 1 or 2, **characterized in that** the conductor receiving opening (12, 22) is arranged in such a way that an electrical conductor can be inserted into the conductor receiving opening (12, 22) on the component side (32) of the printed circuit board (30).

4. Arrangement according to one of Claims 1 to 3, **characterized in that** the conductor receiving opening (12, 22) is arranged in such a way that an electrical conductor can be inserted into the conductor receiving opening (12, 22) in a direction parallel to the plane of the printed circuit board (30).

5. Arrangement according to one of Claims 1 to 4, **characterized in that** the operator control opening (13, 23) is arranged in a direction parallel to the conductor receiving opening (12, 22) or in a direction perpendicular to the conductor receiving opening (12, 22) .

6. Use of a printed circuit board passage terminal (10, 20) for arrangement on a printed circuit board (30),
wherein the printed circuit board (30) has a solder side (31) and a component side (32)
and a recess (34, 35) for receiving the printed circuit board passage terminal (10, 20) is arranged in the printed circuit board (30),
wherein the printed circuit board passage terminal (10, 20) has a housing (11, 21) with a conductor receiving opening (12, 22) for receiving an electrical conductor and with an operator control opening (13, 23) for fixing or releasing an electrical conductor which is inserted into the conductor receiving opening (12, 22), comprises a contact element (14, 24) for soldering and electrically contact-connecting the printed circuit board passage terminal (10, 20) to the solder side (31) of the printed circuit board (30) and
has a flange component (15, 25) with an outer face (151, 251) and a support face (152, 252), and, in the printed circuit board passage terminal (10, 20) which is arranged in the recess (34, 35) of the printed circuit board (30), the flange component (15, 25), by way of the support face (152, 252), is fixed on the solder side (31) of the printed circuit board (30),
wherein an outer wall (111, 211) of the housing (11, 21) of the printed circuit board passage terminal (10, 20) is arranged in a plane parallel to the plane of the support face (152, 252) of the flange component (15, 25), and
wherein the printed circuit board passage terminal (20) is arranged on the printed circuit board (30) in such a way that the support face (252) of the flange component (25) is supported on the solder side (31) of the printed circuit board (30) and at least a subregion of the outer wall (211) of the housing (21) rests on the component side (32) of the printed circuit board (30), **characterized in that** the contact element (14) is in the form of a solder pin, wherein the solder pin is arranged on the outer wall (211) of the housing (20) in a direction perpendicular to the plane of the outer wall (211), a slot (351) is formed in the recess (35) of the printed circuit board (30), and the printed circuit board passage terminal (20) is arranged in the recess (35) of the printed circuit board (30) in such a way that the solder pin engages into the slot (351) and is soldered to the solder side (31) of the printed circuit board (30).

7. Method for arranging a printed circuit board passage terminal (10, 20) on a printed circuit board (30),
wherein the printed circuit board (30) has a solder side (31) and a component side (32)
and a recess (34, 35) for receiving the printed circuit board passage terminal (10, 20) is arranged in the printed circuit board (30),
wherein the printed circuit board passage terminal (10, 20) has a housing (11, 21) with a conductor receiving opening (12, 22) for receiving an electrical conductor and with an operator control opening (13, 23) for fixing or releasing an electrical conductor which is inserted into the conductor receiving opening (12, 22), comprises a contact element (14, 24) for soldering and electrically contact-connecting the printed circuit board passage terminal (10, 20) to the solder side (31) of the printed circuit board (30) and
has a flange component (15, 25) with an outer face (151, 251) and a support face (152, 252),
and wherein the printed circuit board passage terminal (10, 20) is inserted into the recess (34, 35) of the printed circuit board (30) in a direction perpendicular to the plane of the printed circuit board (30), wherein the flange component (15, 25), by way of the support face (152, 252), is supported on the solder side (31) of the printed circuit board (30), or the printed circuit board passage terminal (10, 20) is pushed into the recess (34, 35) of the printed circuit board (30) in a direction parallel to the plane of the printed circuit board (30), wherein the flange component (15, 25), by way of the support face (152, 252), is supported on the solder side (31) of the printed circuit board (30),
wherein an outer wall (111, 211) of the housing (11, 21) of the printed circuit board passage terminal (10, 20) is arranged in a plane parallel to the plane of the support face (152, 252) of the flange component (15, 25), and
wherein the printed circuit board passage terminal (20) is arranged on the printed circuit board (30) in such a way that the support face (252) of the flange component (25) is supported on the solder side (31) of the printed circuit board (30) and at least a subregion of the outer wall (211) of the housing (21) rests on the component side (32) of the printed circuit board (30), **characterized in that** the contact element (14) is in the form of a solder pin, wherein the solder pin is arranged on the outer wall (211) of the housing (20) in a direction perpendicular to the plane of the outer wall (211), a slot (351) is formed in the recess (35) of the printed circuit board (30), and the printed circuit board passage terminal (20) is arranged in the recess (35) of the printed circuit board (30) in such a way that the solder pin engages into the slot (351) and is soldered to the solder side (31) of the printed circuit board (30).

## Revendications

1. Agencement, comportant une borne à enfoncer pour carte de circuit imprimé (10, 20) et une carte de circuit imprimé (30),
dans lequel la carte de circuit imprimé (30) comporte une face de brasage (31) et une face de composant (32) et un évidement (34, 35) servant à recevoir la borne à enfoncer pour carte de circuit imprimé (10, 20) est disposé dans la carte de circuit imprimé (30),
dans lequel la borne à enfoncer pour carte de circuit imprimé (10, 20) comporte un boîtier (11, 21) pourvu d'une ouverture de réception de conducteur (12, 22) servant à recevoir un conducteur électrique et d'une ouverture de service (13, 23) servant à fixer ou à détacher un conducteur électrique introduit dans l'ouverture de réception de conducteur (12, 22),
un élément de contact (14) servant à braser et à mettre en contact électrique la borne à enfoncer pour carte de circuit imprimé (10, 20) avec la face de brasage (31) de la carte de circuit imprimé (30) et
comporte un élément à bride (15, 25) pourvu d'une surface extérieure (151, 251) et d'une surface d'appui (152, 252)
et, lorsque la borne à enfoncer pour carte de circuit imprimé (10, 20) est disposée dans l'évidement (34, 35) de la carte de circuit imprimé (30), le composant à bride (15, 25) repose par la surface d'appui (152, 252) sur la face de brasage (31) de la carte de circuit imprimé (30),
dans lequel une paroi extérieure (111, 211) du boîtier (11, 21) de la borne à enfoncer pour carte de circuit imprimé (10, 20) est disposée dans un plan parallèle au plan de la surface d'appui (152, 252) du composant à bride (15, 25) et
dans lequel la borne à enfoncer pour carte de circuit imprimé (20) est disposée sur la carte de circuit imprimé (30) de manière à ce que la surface d'appui (252) du composant à bride (25) repose sur la face de brasage (31) de la carte de circuit imprimé (30) et à ce qu'au moins une zone partielle de la paroi extérieure (211) du boîtier (21) repose sur la face de composant (32) de la carte de circuit imprimé (30), **caractérisé en ce que** l'élément de contact (14) est réalisé sous la forme d'une broche à braser, dans lequel la broche à braser est disposée sur la paroi extérieure (211) du boîtier (20) dans une direction perpendiculaire au plan de la paroi extérieure (211), **en ce qu'**une fente (351) est ménagée dans l'évidement (35) de la carte de circuit imprimé (30) et **en ce que** la borne à enfoncer pour carte de circuit imprimé (20) est disposée dans l'évidement (35) de la carte de circuit imprimé (30) de manière à ce que la broche à braser s'engage dans la fente (351) et soit brasée à la face de brasage (31) de la carte de circuit imprimé (30) .

2. Agencement selon la revendication 1, **caractérisé en ce que** la carte de circuit imprimé (30) comporte une zone de bord (33) et **en ce que** l'évidement (34, 35) est disposé dans la zone de bord (33) de la carte de circuit imprimé (30).

3. Agencement selon la revendication 1 ou 2, **caractérisé en ce que** l'ouverture de réception de conducteur (12, 22) est disposée de manière à ce qu'un conducteur électrique puisse être introduit dans l'ouverture de réception de conducteur (12, 22) sur la face de composant (32) de la carte de circuit imprimé (30) .

4. Agencement selon l'une des revendications 1 à 3, **caractérisé en ce que** l'ouverture de réception de conducteur (12, 22) est disposée de manière à ce qu'un conducteur électrique puisse être introduit dans l'ouverture de réception de conducteur (12, 22) dans une direction parallèle au plan de la carte de circuit imprimé (30).

5. Agencement selon l'une des revendications 1 à 4, **caractérisé en ce que** l'ouverture de service (13, 23) est disposée dans une direction parallèle à l'ouverture de réception de conducteur (12, 22) ou dans une direction perpendiculaire à l'ouverture de réception de conducteur (12, 22).

6. Utilisation d'une borne à enfoncer pour carte de circuit imprimé (10, 20) destinée à être disposée sur une carte de circuit imprimé (30),
dans laquelle la carte de circuit imprimé (30) comporte une face de brasage (31) et une face de composant (32) et un évidement (34, 35) servant à recevoir la borne à enfoncer pour carte de circuit imprimé (10, 20) est ménagé dans la carte de circuit imprimé (30),
dans laquelle la borne à enfoncer pour carte de circuit imprimé (10, 20) comporte un boîtier (11, 21) pourvu d'une ouverture de réception de conducteur (12, 22) servant à recevoir un conducteur électrique et d'une ouverture de service (13, 23) servant à fixer ou à détacher un conducteur électrique introduit dans l'ouverture de réception de conducteur (12, 22), comprend un élément de contact (14, 24) servant à braser et à mettre en contact électrique la borne à enfoncer pour carte de circuit imprimé (10, 20) avec la face de brasage (31) de la carte de circuit imprimé (30) et
comporte un élément à bride (15, 25) pourvu d'une surface extérieure (151, 251) et d'une surface d'appui (152, 252) et, lorsque la borne à enfoncer pour carte de circuit imprimé (10, 20) est disposée dans l'évidement (34, 35) de la carte de circuit imprimé (30), le composant à bride (15, 25) est fixé par la surface d'appui (152, 252) sur la face de brasage (31) de la carte de circuit imprimé (30),
dans laquelle une paroi extérieure (111, 211) du boîtier (11, 21) de la borne à enfoncer pour carte de circuit imprimé (10, 20) est disposée dans un plan parallèle au plan de la surface d'appui (152, 252) du composant à bride (15, 25) et
dans laquelle la borne à enfoncer pour carte de circuit imprimé (20) est disposée sur la carte de circuit imprimé (30) de manière à ce que la surface d'appui (252) du composant à bride (25) repose sur la face de brasage (31) de la carte de circuit imprimé (30) et à ce qu'au moins une zone partielle de la paroi extérieure (211) du boîtier (21) repose sur la face de composant (32) de la carte de circuit imprimé (30), **caractérisée en ce que** l'élément de contact (14) est réalisé sous la forme d'une broche à braser, dans laquelle la broche à braser est disposée sur la paroi extérieure (211) du boîtier (20) dans une direction perpendiculaire au plan de la paroi extérieure (211), **en ce qu'**une fente (351) est ménagée dans l'évidement (35) de la carte de circuit imprimé (30) et **en ce que** la borne à enfoncer pour carte de circuit imprimé (20) est disposée dans l'évidement (35) de la carte de circuit imprimé (30) de manière à ce que la broche à braser s'engage dans la fente (351) et soit brasée à la face de brasage (31) de la carte de circuit imprimé (30) .

7. Procédé pour disposer une borne à enfoncer pour carte de circuit imprimé (10, 20) sur une carte de circuit imprimé (30),
dans lequel la carte de circuit imprimé (30) comporte une face de brasage (31) et une face de composant (32) et un évidement (34, 35) servant à recevoir la borne à enfoncer pour carte de circuit imprimé (10, 20) est disposé dans la carte de circuit imprimé (30),
dans lequel la borne à enfoncer pour carte de circuit imprimé (10, 20) comporte un boîtier (11, 21) pourvu d'une ouverture de réception de conducteur (12, 22) servant à recevoir un conducteur électrique et d'une ouverture de service (13, 23) servant à fixer ou à détacher un conducteur électrique inséré dans l'ouverture de réception de conducteur (12, 22), comprend un élément de contact (14, 24) servant à braser et à mettre en contact électrique la borne à enfoncer pour carte de circuit imprimé (10, 20) avec la face de brasage (31) de la carte de circuit imprimé (30) et
comporte un composant à bride (15, 25) pourvu d'une surface extérieure (151, 251) et d'une surface d'appui (152, 252)
et dans lequel la borne à enfoncer pour carte de circuit imprimé (10, 20) est enfichée dans l'évidement (34, 35) de la carte de circuit imprimé (30) dans une direction perpendiculaire au plan de la carte de circuit imprimé (30), dans lequel le composant à bride (15, 25) pourvu de la surface d'appui (152, 252) repose sur la face de brasage (31) de la carte de circuit imprimé (30), ou la borne à enfoncer pour carte de circuit imprimé (10, 20) imprimé est insérée dans l'évidement (34, 35) de la carte de circuit imprimé (30) dans une direction parallèle au plan de la carte de circuit imprimé (30), dans lequel le composant à bride (15, 25) pourvu de la surface d'appui (152, 252) repose sur la face de brasage (31) de la carte de circuit imprimé (30),
dans lequel une paroi extérieure (111, 211) du boîtier (11, 21) de la borne à enfoncer pour carte de circuit imprimé (10, 20) est disposée dans un plan parallèle au plan de la surface d'appui (152, 252) du composant à bride (15, 25) et
dans lequel la borne à enfoncer pour carte de circuit imprimé (20) est disposée sur la carte de circuit imprimé (30) de manière à ce que la surface d'appui (252) du composant à bride (25) repose sur la face de brasage (31) de la carte de circuit imprimé (30) et à ce qu'au moins une zone partielle de la paroi extérieure (211) du boîtier (21) repose sur la face de composant (32) de la carte de circuit imprimé (30), **caractérisé en ce que** l'élément de contact (14) est réalisé sous la forme d'une broche à braser, dans lequel la broche à braser est disposée sur la paroi extérieure (211) du boîtier (20) dans une direction perpendiculaire au plan de la paroi extérieure (211), **en ce qu'**une fente (351) est ménagée dans l'évidement (35) de la carte de circuit imprimé (30) et **en ce que** la borne à enfoncer pour carte de circuit imprimé (20) est disposée dans l'évidement (35) de la carte de circuit imprimé (30) de manière à ce que la broche à braser s'engage dans la fente (351) et soit brasée à la face de brasage (31) de la carte de circuit imprimé (30) .
